# EUROPEAN PATENT APPLICATION

(11) **EP 4 436 348 A1**
(43) Date of publication of application: **25.09.2024**
(21) Application number: 22918185.4
(22) Date of filing: 16.08.2022
(51) Int. Cl.: H10K 71/10, H10K 50/80, H01L 33/00, H01L 33/52

(54) **DISPLAY DEVICE AND DISPLAY DEVICE MANUFACTURING METHOD**

(30) Priority: 04.01.2022 CN 202210001108
(71) Applicant: Taizhou Guanyu Technology Co., Ltd., Taizhou, Zhejiang 318057 (CN)
(72) Inventor: LIN, Maochung, Taizhou, Zhejiang 318057 (CN); LIU, Yi-cheng, Taiwan (CN); CHEN, Huei-siou, Datong (CN); SU, Chiu Yen, Tainan City 730002, Taiwan (CN)
(74) Representative: Michalski Hüttermann & Partner Patentanwälte mbB
(86) International application number: PCT/CN2022/112732
(87) International publication number: WO 2023/130729

(57) **Abstract**

The present disclosure provides a display device and a method for manufacturing a display device. The method for manufacturing a display device of the present disclosure includes: forming a light emitting layer, a first metal layer and a protective layer on a substrate, wherein the first metal layer is located between the light emitting layer and the protective layer; forming a release layer covering over the light emitting layer, the first metal layer and the protective layer; removing a first portion of the release layer to expose the light emitting layer and the first portion of the first metal layer; and forming a first encapsulation layer covering the light emitting layer, a first portion of the first metal layer and a second portion of the release layer. A thickness of the first encapsulation layer on the light emitting layer is substantially equal to a thickness of the first encapsulation layer on the first portion of the first metal layer.

## Description

### BACKGROUND OF THE PRESENT DISCLOSURE

### FIELD OF THE PRESENT DISCLOSURE

The present disclosure relates to a display device and a method for manufacturing a display device, and more particularly to a display device including a narrow bezel with an encapsulation layer having a same thickness and a manufacturing method thereof.

### DESCRIPTION OF THE PRIOR ART

Display devices are extensively used in most electronic apparatuses, and there has been an increasing demand for thinner and lighter display devices in the recent years. However, a method for manufacturing a display device faces an issue of difficulties in reducing a bezel. In fact, one commonly known challenge in the field is how to narrow a bezel of a display. Thus, the industry of display devices seeks a method for solving the issues above.

### SUMMARY OF THE PRESENT DISCLOSURE

A method for manufacturing a display device includes: forming a light emitting layer, a first metal layer and a protective layer on a substrate, wherein the first metal layer is located between the light emitting layer and the protective layer; forming a release layer covering over the light emitting layer, the first metal layer and the protective layer; removing a first portion of the release layer to expose the light emitting layer and a first portion of the first metal layer; and forming a first encapsulation layer covering the light emitting layer, the first portion of the first metal layer and a second portion of the release layer, wherein a thickness of the first encapsulation layer on the light emitting layer is substantially equal to a thickness of the first encapsulation layer on the first portion of the first metal layer.

In some embodiments, the first portion of the first metal layer is adjacent to the light emitting layer.

In some embodiments, the second portion of the release layer and the first encapsulation layer on the second portion of the release layer are removed.

In some embodiments, a release force between the first metal layer and the first encapsulation layer is greater than a release force between the first metal layer and the second portion of the release layer.

In some embodiments, the release layer includes a fluorine compound.

In some embodiments, the first encapsulation layer is formed by means of plasma enhanced chemical vapor deposition (PECVD), and a resistance of the release layer against the PECVD process prevents the release layer from being impaired by the PECVD process.

In some embodiments, a release force of the release layer is less than 10 g/mm.

In some embodiments, the method further includes: forming an electrode on the substrate; and forming the second portion of the release layer on the electrode, wherein the electrode is adjacent to the protective layer.

In some embodiments, the method further includes: forming a second metal layer on the substrate, wherein the light emitting layer is located between the first metal layer and the second metal layer; and forming the third portion of the release layer on a portion of the second metal layer away from the light emitting layer, wherein the first encapsulation layer covers over the third portion of the release layer and a portion of the second metal layer close to the light emitting layer.

In some embodiments, a thickness of the first encapsulation layer on the light emitting layer is substantially equal to a thickness of the first encapsulation layer on a portion of the second metal layer close to the light emitting layer.

A display device includes a substrate, a light emitting layer, a metal layer, a protective layer and a first encapsulation layer. The light emitting layer is disposed on the substrate. The metal layer is disposed on the substrate. The protective layer is disposed on the substrate. The metal layer is located between the light emitting layer and the protective layer. The first encapsulation layer covers the light emitting layer and a first portion of the metal layer. A thickness of the first encapsulation layer on the light emitting layer is substantially equal to a thickness of the first encapsulation layer on the first portion of the metal layer.

In some embodiments, the display device further includes an electrode and a second encapsulation layer. The electrode is disposed on the substrate. The second encapsulation layer covers the substrate and is close to the electrode. A difference between a thickness of the second encapsulation layer next to the electrode and a thickness of the first encapsulation layer on the light emitting layer is less than 10%.

In some embodiments, the thickness of the second encapsulation layer next to the electrode is substantially equal to the thickness of the first encapsulation layer on the light emitting layer.

In some embodiments, the first encapsulation layer includes a relatively rough surface, which is between a first sidewall and a second sidewall of the metal layer.

### BRIEF DESCRIPTION OF THE DRAWINGS

FIGS. 1A to FIG. 1H are schematic diagrams of a display device in different manufacturing stages of a method according to some embodiments of the present disclosure;
FIGS. 2A to FIG. 2J are schematic diagrams of a display device in different manufacturing stages of a method according to some embodiments of the present disclosure;
FIG. 3A is a plan view of a display device according to some embodiments;
FIG. 3B is a section diagram of a display device according to some embodiments;
FIG. 4A is a plan view of a display device according to some embodiments;
FIG. 4B is a section diagram of a display device according to some embodiments;
FIG. 5A is a plan view of a display device according to some embodiments;
FIG. 5B is a section diagram of a display device according to some embodiments; FIG. 6A is a plan view of a display device according to some embodiments;
FIGS. 6B to 6D are section diagrams of a display device according to some embodiments; FIG. 7 is a section diagram of a display device according to some embodiments;
FIG. 8 is a section diagram of a display device according to some embodiments; and
FIG. 9 is a flowchart of a method for manufacturing a display device according to some embodiments.

### DETAILED DESCRIPTION OF THE EMBODIMENTS

Numerous different embodiments or examples are provided in the present disclosure below to implement different characteristics of the present application. Specific examples of components and configurations are as described below in the aim of simplifying the disclosure of the present application. It should be noted that these examples are nonlimiting and are not to be construed as restriction to the present application. For example, forming a first feature on or over/above a second feature can include an embodiment in which the first and second features are in direct contact, and can further include an embodiment in which another feature is formed between the first and second features such that the first and second features are not in direct contact. Moreover, numerals, symbols and/or letters may be repeated for components in different examples of the present application. Such repetition is for the purpose of simplicity and clarity, and does not dictate relations between the various embodiments and/or structures discussed.

In addition, terms used for spatial correspondence, for example, simple description of terms such as below", "lower than", "lower", "higher than", "higher" and the like are used to describe a relation of one component or feature with respect to another component or feature. In addition to orientations illustrated in the drawings, these terms for spatial correspondence further include different orientations of a device in use or in operation. A device can be oriented (rotated by 90 degrees or other orientations), and the spatial correspondence description used in the present application can be interpreted accordingly.

Despite that numeric ranges and parameters disclosed in the broadest range of the present disclosure are approximate values, the values stated in specific embodiments are to be as accurate as possible. However, any numeral intrinsically includes a certain error caused by a standard deviation obtained from individual testing and measurement. Moreover, in the literature below, the term "about/approximate" usually refers to less than 10%, 5%, 1% or 0.5% of a predetermined value or range. Alternatively, the terms "substantially" and "about/approximate" refer to within an acceptable standard error of a mean value considered by a person of ordinary skill in the art. Apart from operation/working examples, unless otherwise specified, it is to be understood that the amount, period of time, temperature, operating conditions, ratio of quantity of materials, as well as all numerical ranges, quantities, values and ratios of the like, are to be modified by the terms "substantially" and "bout/approximate" in all circumstances. Thus, unless described otherwise, the numerical values and parameters of the claims set forth in the present disclosure can be regarded as approximate value that are variable according to requirements. Each numerical value or parameter is to be interpreted at least in light of a quantity of effective numbers reported and by applying common rounding techniques. In the present literature, a range can represent from one endpoint to the other endpoint, or between these two endpoints. Unless otherwise specified, all ranges disclosed in the present literature include endpoints.

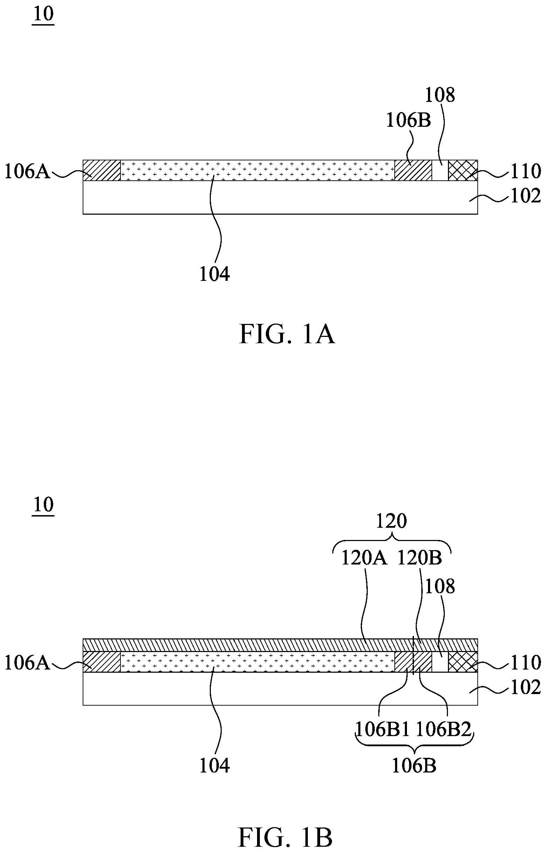

FIGS. 1A to 1H show schematic diagrams of a display device 10 in different manufacturing stages of a method according to some embodiments of the present disclosure.

In some embodiments, the display device 10 includes a substrate 102, a light emitting layer 104, metal layers 106A and 106B, a protective layer 108 and an electrode 110. As shown in FIG. 1A, the light emitting layer 104, the metal layers 106A and 106B, the protective layer 108 and the electrode 110 are formed over the substrate 102. The light emitting layer 104 is formed between the metal layer 106A and the metal layer 106B. The metal layer 106B is formed between the light emitting layer 104 and the protective layer 108. The protective layer 108 is formed between the metal layer 106B and the electrode 110.

In some embodiments, the substrate 102 can include a base material (not shown), a dielectric layer (not shown), and one or more circuits (not shown) disposed on the base material or in the base material. In some embodiments, the base material is a transparent base material, or is at least a portion thereof is transparent. In some embodiments, the base material is a non-flexible base material, and a material of such base material can include glass, quartz, low-temperature polysilicon (LTPS) or other appropriate materials. In some embodiments, the base material is a flexible base material, and a material of such base material can include transparent epoxy resin, polyimide, polyvinyl chloride, methyl methacrylate or other appropriate materials. The dielectric layer is disposed on the base material as needed. In some embodiments, the dielectric layer can include silicon oxide, silicon nitride, silicon oxynitride, or other appropriate materials.

Moreover, the circuit can include a complementary metal oxide semiconductor (CMOS) circuit, or multiple transistors and multiple capacitors adjacent to the transistors, wherein the transistors and the capacitors are formed on the dielectric layer. In some embodiments, each of the transistors is a thin-film transistor (TFT). Each of the transistors includes a source/drain region (including at least one source region and one drain region), a channel region located in the source-drain region, a gate electrode disposed above the channel region, and a gate insulator located between the channel region and the gate electrode. The channel region of the transistor can be formed of a semiconductor material, for example, silicon or other elements selected from group IV or group III and group V.

In some embodiments, the light emitting layer 104 can be an organic light emitting diode (OLED), a micro light emitting diode (LED) or mini LED, a quantum dot LED (QLED) or other appropriate light emitting materials. In some embodiments, the light emitting layer 104 includes different materials so as to emit light of different wavelengths within different wavebands. For example, the light emitting layer 104 is configured to emit light including red light (for example, light having a wavelength ranging between 620 nm and 780 nm), green light (for example, light having a wavelength ranging between 500 nm and 580 nm) and/or blue light (for example, light having a wavelength ranging between 400 nm and 500 nm).

In some embodiments, the metal layers 106A and 106B can include aluminum, tungsten, gold, platinum, cobalt, other suitable metal materials, an alloy of the above, or a combination of the above. The metal layers 106A and 106B can also include a metal carbide, a metal nitride, other suitable metal materials, or a combination of the above.

In some embodiments, the protective layer 108 can be made of a dielectric material. The dielectric material can include silicon oxide, silicon nitride, silicon oxynitride, silicon carbide, other suitable dielectric materials, or a combination of the above. In some embodiments, the protective layer 108 is made of polycrystalline silicon, amorphous silicon, silicon nitride, spin-on glass (SOG), other suitable materials, or a combination of the above.

In some embodiments, the electrode 110 includes a metal material, for example, silver (Ag) and magnesium (Mg). In some embodiments, the electrode 110 includes indium tin oxide, (ITO), indium zinc oxide (IZO) or other appropriate materials.

In the embodiment in FIG. 1B, the release layer 120 is formed over the light emitting layer 104, the metal layers 106A and 106B, the protective layer 108 and the electrode 110. In some embodiments, the release layer 120 can include two portions 120A and 120B (for example, separated by a dotted line in FIG. 1B). The two portions 120A and 120B of the release layer 120 can be defined by means of a photolithography process.

In some embodiments, the release layer 120 can be formed over the light emitting layer 104, the metal layers 106A and 106B, the protective layer 108 and the electrode 110 by means of coating or spraying. In some embodiments, a thickness of the release layer 120 can be less than 15 um, for example, between about 1 um and about 10 um. In the present disclosure, the release layer can also be referred to as a release film, a peel film, or a separating film.

In some embodiments, the release layer 120 can include a photoresist material, for example, carbon, hydrogen, oxygen, other appropriate materials, or a combination of the above. In some embodiment, the release layer 120 can include a fluorine compound, for example, fluorinated silicate. In some embodiment, the release layer 120 can include silicone. In some embodiments, a side surface of the release layer 120 can be coated with a release agent with separation properties. In some embodiment, a release force of the release layer 120 can be less than 15 g/mm, for example, less than 10 g/mm. When the release layer 120 is removed, a material carried by the release layer 120 can also be removed altogether.

In some embodiments, the metal layer 106B can include two portions 106B1 and 106B2 (for example, separated by a dotted line in FIG. 1B). The portion 106B 1 of the metal layer 106B is adjacent to the light emitting layer 104, and the portion 106B2 of the metal layer 106B is adjacent to the protective layer 108. In some embodiments, the release layer 120 can be patterned by means of a photolithography process. The portion 120A of the release layer 120 can cover over the metal layer 106A, the light emitting layer 104 and the portion 106B1 of the metal layer 106B. The portion 120B of the release layer 120 can cover over the electrode 110 and the portion 106B2 of the metal layer 106B.

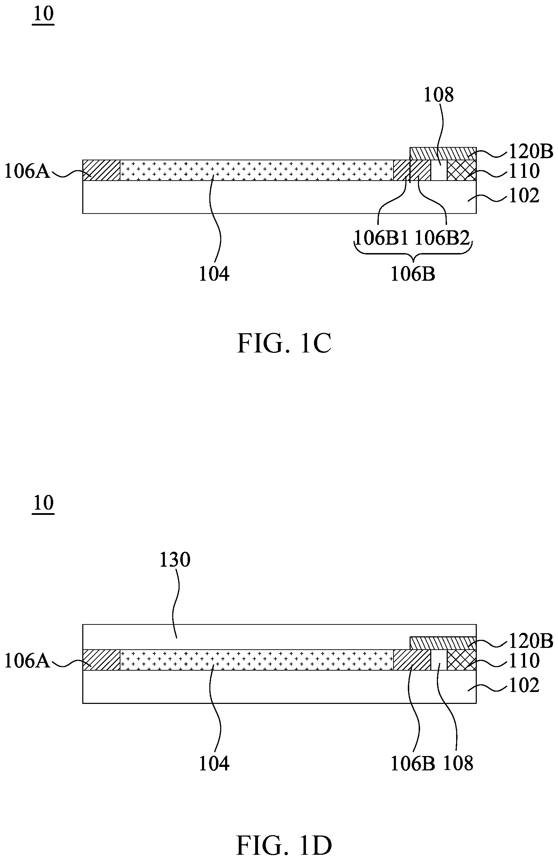

In the embodiment in FIG. 1C, the portion 120A of the release layer 120 is removed to expose the metal layer 106A, the light emitting layer 104 and the portion 106B1 of the metal layer 106B.

In the embodiment in FIG. 1D, thin-film encapsulation (TFE) is performed on the display device 10. In some embodiments, the encapsulation layer 130 is formed over the metal layer 106A, the light emitting layer 104, the portion 106B1 of the metal layer 106B and the release layer 120B. In some embodiments, the encapsulation layer 130 can be formed by means of plasma enhanced chemical vapor deposition (PECVD). In some embodiments, the encapsulation layer 130 can be an inorganic material. In some embodiment, the encapsulation layer 130 can include silicon oxide, silicon nitride, silicon oxynitride, silicon carbide, other suitable inorganic materials, or a combination of the above.

In some embodiments, a resistance of the release layer 120 against the PECVD process prevents the release layer 120 from being impaired by the PECVD process.

In some embodiments, a release force between the metal layer 106B and the encapsulation layer 130 is greater than a release force between the metal layer 106B and the portion 120B of the release layer 120. Thus, the portion 120B of the release layer 120 and a portion of the encapsulation layer 130 thereon can be easily removed, while leaving the encapsulation layer 130 still covering the metal layer 106B, the light emitting layer 104 and the portion 106B1 of the metal layer 106B. In some embodiments, a thickness of the encapsulation layer 130 on the light emitting layer 104 is substantially equal to a thickness of the encapsulation layer 130 on the portion 106B 1 of the metal layer 106B.

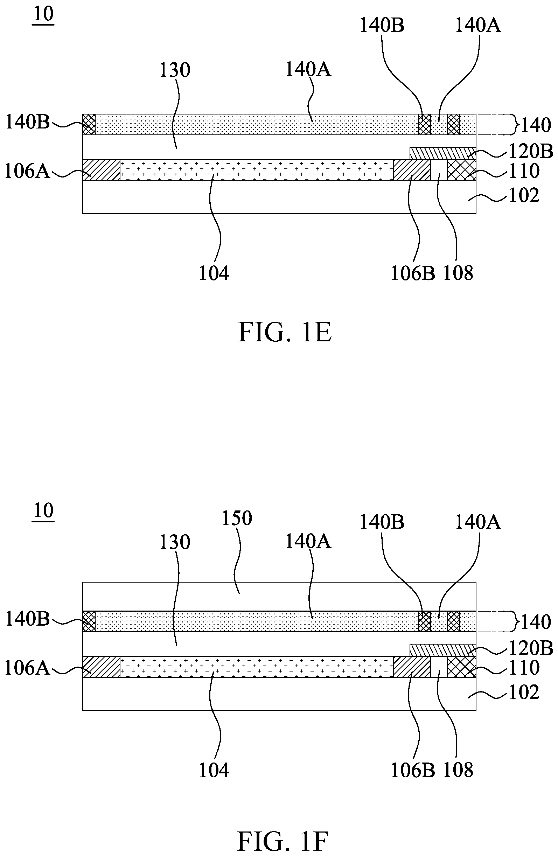

In the embodiment in FIG. 1E, another encapsulation layer 140 is formed on the encapsulation layer 130. In some embodiments, the encapsulation layer 140 can be coated on the encapsulation layer 130. In some embodiments, the encapsulation layer 140 can include a top glue 140A and a frame glue 140B. In some embodiments, the encapsulation layer 140 can include a plurality of top glues 140A and a plurality of frame glues 140B, and he top glues 140A and the frame glues 140B can be alternately arranged. In some embodiments, at least one top glue 140A can be formed above the light emitting layer 104. In some embodiments, the frame glue 140B can be formed above the release layer 120.

In the embodiment in FIG. 1F, a cover layer 150 can be formed over the encapsulation layer 140. In some embodiments, the cover layer 150 can include glass, for example, borosilicate glass (BSG), phosphoric silicate glass (PSG), borophosphosilicate glass (BPSG), fluorinated silicate glass (FSG), other materials having low dielectric constants, or a combination of the above.

In some embodiments, the cover layer 150 and the encapsulation layer 140 can be pressed together for further encapsulation of the display device 10. In some embodiments, the top glue 140A and the frame glue 140B are cured, so as to reinforce the encapsulation capability of the top glue 140A and the frame glue 140B.

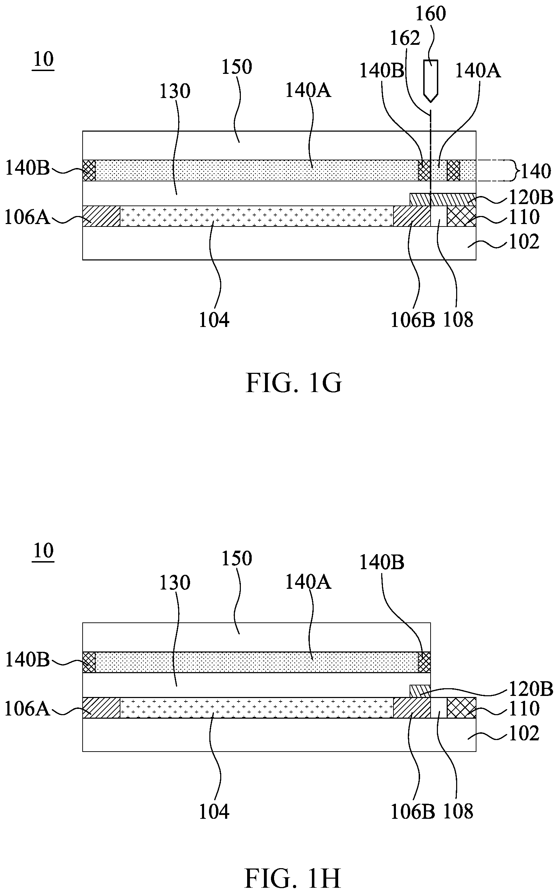

In the embodiment in FIG. 1G, a cutting mold 160 is used to cut the display device 10 along an axis 162. In some embodiments, the axis 162 can coincide with or pass through a contact surface between the metal layer 106B and the protective layer 108. In some embodiments, the axis 162 can coincide with or pass through a sidewall of one frame glue 140B. In some embodiments, the axis 162 can pass through the portion 120B of the release layer 120, the protective layer 130 and the cover layer 150.

In the embodiment in FIG. 1H, the encapsulation layer 130, the encapsulation layer 140, the cover layer 150, and the portion 120B of the release layer 120 over the protective layer 108 and the electrode 110 are removed. In some embodiments, the portion 120B of the release layer 120 over the metal layer 160B is not removed.

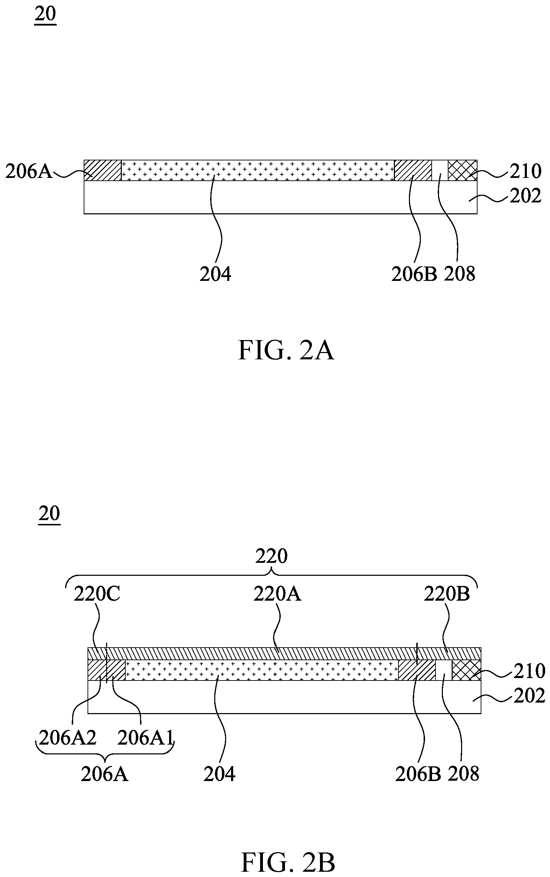

FIGS. 2A to FIG. 2J shows schematic diagrams of a display device 20 in different manufacturing stages of a method according to some embodiments of the present disclosure. The display device 20 disclosed in FIGS. 2A to 2J primarily differs from the display device 10 disclosed in FIGS. 1A to 1H in terms of an order of performing cutting and release.

As shown in FIG. 2A, a light emitting layer 204, metal layers 206A and 206B, a protective layer 208 and an electrode 210 are formed over a substrate 202.

In the embodiment in FIG. 1B, the release layer 220 is formed over the light emitting layer 204, the metal layers 206A and 206B, the protective layer 208 and the electrode 210. In some embodiments, the release layer 220 can include three portions 220A, 220B and 220C. The three portions 220A, 220B and 220C of the release layer 220 can be defined by a photolithography process.

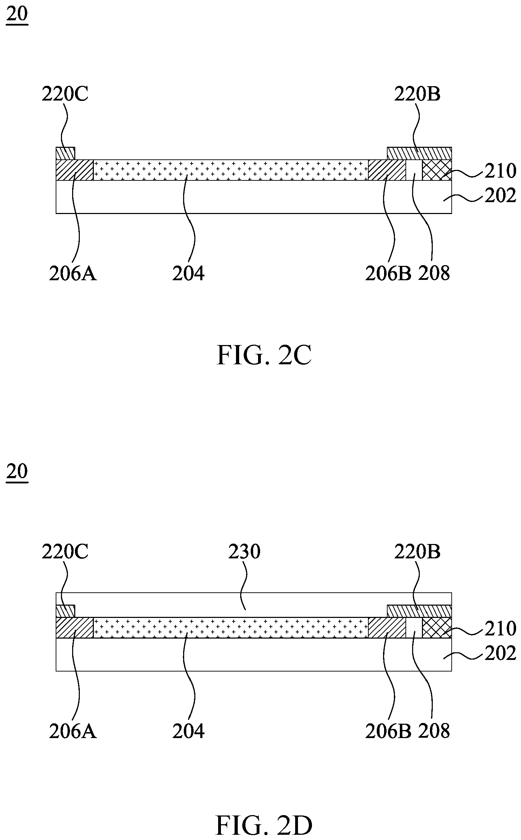

In the embodiment in FIG. 2C, the portion 220A of the release layer 220B is removed. Once the portion 220A of the release layer 220 is removed, the light emitting layer 204, a portion of the metal layer 206A and a portion of the metal layer 206B are exposed.

In the embodiment in FIG. 2D, an encapsulation layer 230 is formed over the light emitting layer 204, the metal layer 206A, the metal layer 206B, and the two release layers 220B and 220C.

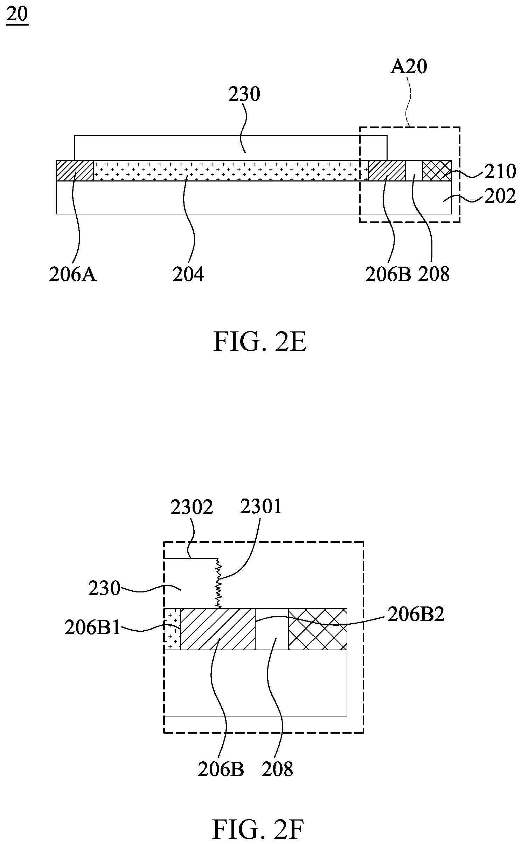

In the embodiment in FIG. 2E, the two release layers 220B and 22C and the encapsulation layer 230 thereon are removed. A region A20 further shows a surface state of the encapsulation layer 230 after the release layer 220C is removed.

FIG. 2F shows an enlarged partial diagram of the region A20. In some embodiments, the encapsulation layer 230 includes a relatively rough surface 2301, which is resulted by removing the release layer 220C and a portion of the encapsulation layer 230 thereon. In some embodiments, the relatively rough surface 2301 is between a sidewall 206B 1 and a sidewall 206B2 of the metal layer 206B. The sidewall 206B 1 of the metal layer 206B is adjacent to the light emitting layer 204. The sidewall 206B2 of the metal layer 206B is adjacent to the protective layer 208.

In some embodiments, the relatively rough surface 2301 is a side surface of the encapsulation layer 230. In some embodiments, the relatively rough surface 2301 is rougher than other surfaces (for example, an upper surface 2302) of the encapsulation layer 230. In some embodiments, the relatively rough surface 2301 is adjacent to the release layer 220B before release. In some embodiments, the relatively rough surface 2301 is in direct contact with the release layer 220B before release. In some embodiments, the relatively rough surface 2301 can be substantially perpendicular to the upper surface of the metal layer 206B.

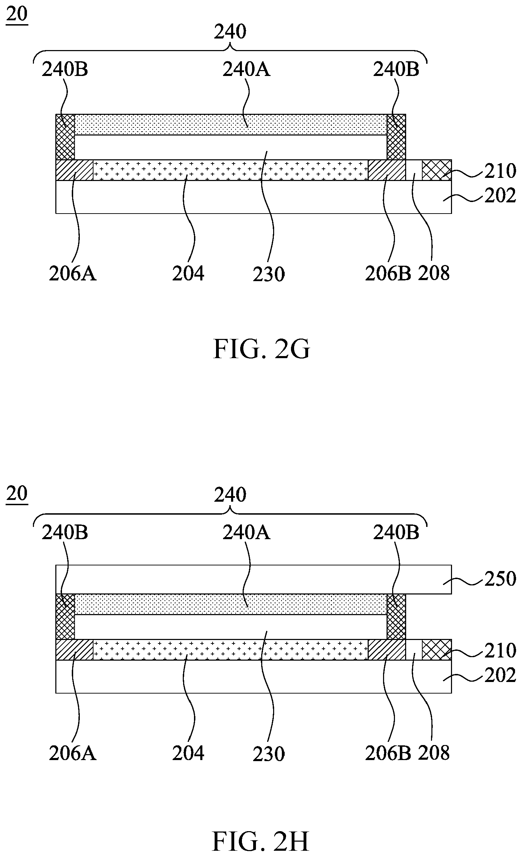

In the embodiment in FIG. 2G, an encapsulation layer 240 is formed to surround the encapsulation layer 230. In some embodiment, the encapsulation layer 240 can include a top glue 240A and a frame glue 240B. In some embodiments, the top glue 240A covers an upper surface of the encapsulation layer 230, and two frame glues 240B are adjacent to two side surfaces of the encapsulation layer 230.

In the embodiment in FIG. 2H, a cover layer 250 is formed over the encapsulation layer 240.

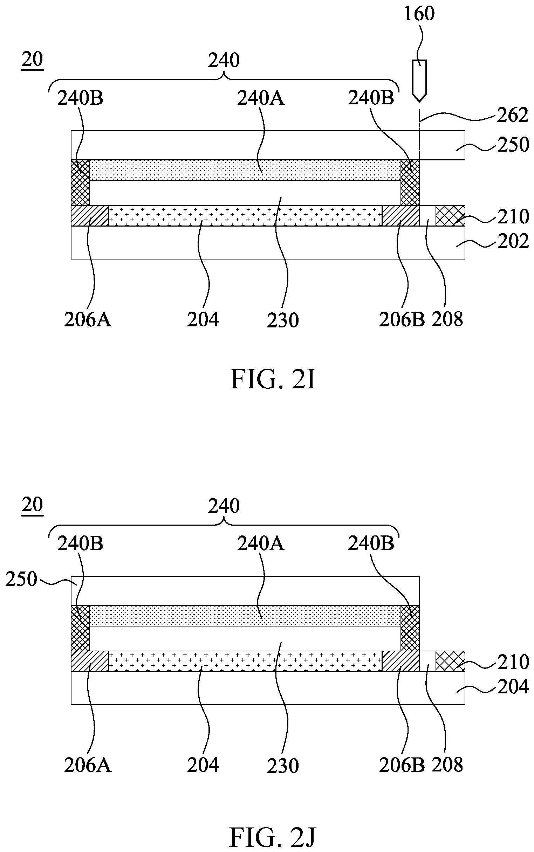

In the embodiment in FIG. 2I, a cutting mold 260 is used to cut the display device 20 along an axis 262.

In the embodiment in FIG. 2J, a portion of the cover layer 250 above the protective layer 208 and the electrode 210 is removed.

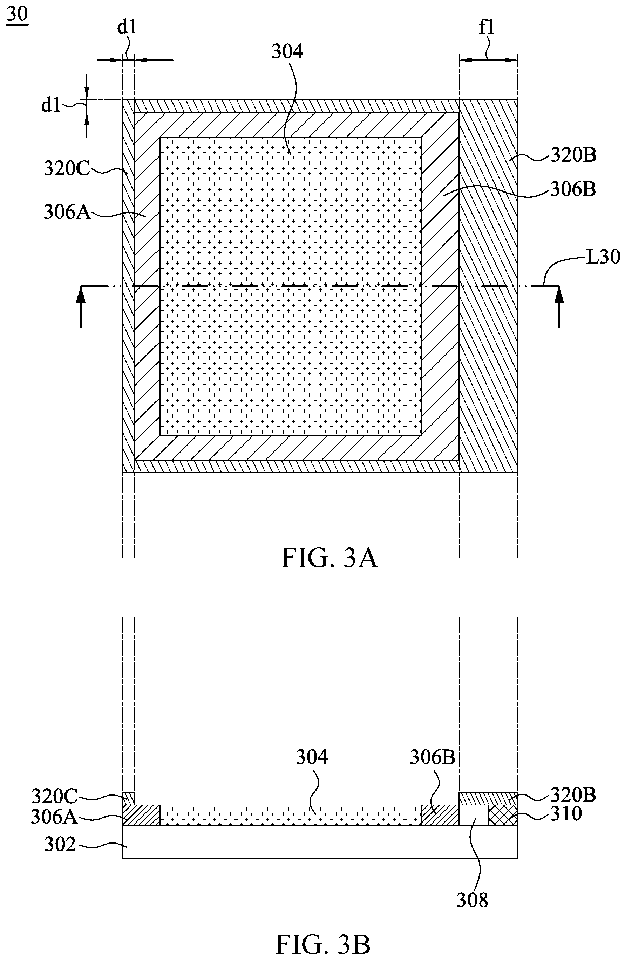

FIG. 3A shows a plan view of a display device 30 according to some embodiments. FIG. 3B shows a section diagram of the display device 30 along an axis L30 according to some embodiments.

In some embodiments, the display device 30 includes a substrate 302, a light emitting layer 304, metal layers 306A and 306B, a protective layer 308, an electrode 310 and release layers 320B and 320C. In some embodiments, the release layer 320B can be formed over the protective layer 308 and the electrode 310. In some embodiments, the release layer 320C can be formed over the metal layer 306A. As shown in FIG. 3B, a width of the release layer 320B is f1 and a width of the release layer 320C is d1.

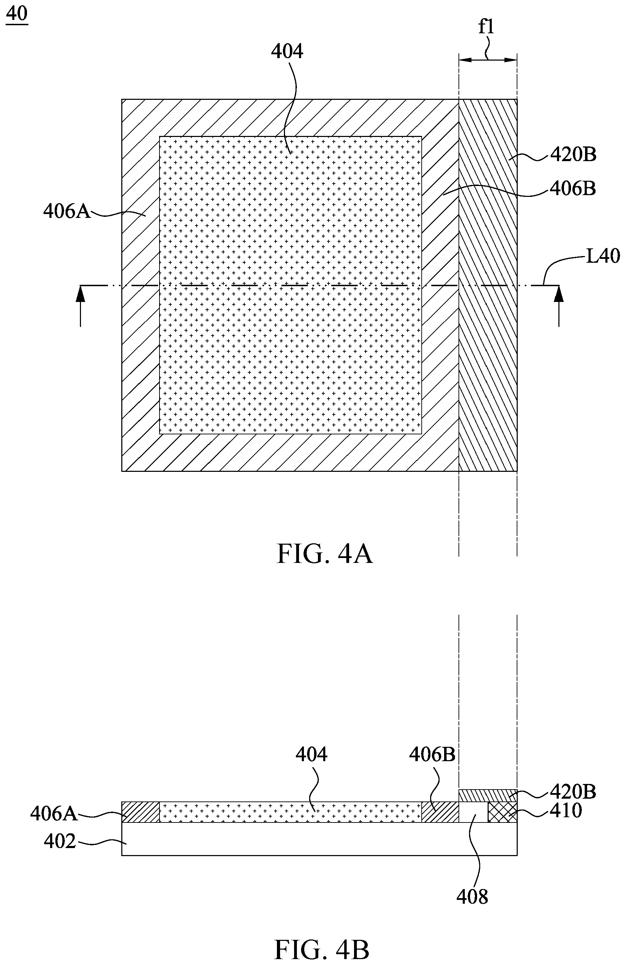

FIG. 4A shows a plan view of a display device 40 according to some embodiments. FIG. 4B shows a section diagram of the display device 40 along an axis L40 according to some embodiments.

In some embodiments, the display device 40 includes a substrate 402, a light emitting layer 404, metal layers 406A and 406B, a protective layer 408, an electrode 410 and a release layer 420B. Compared to the embodiments in FIG. 3A and FIG. 3B, the embodiments in FIG. 4A and FIG. 4B have only one release layer 420B having the width f1. In some embodiments, the release layer 420B can be formed over the protective layer 408 and the electrode 410, and no release layer is formed over the metal layer 406A.

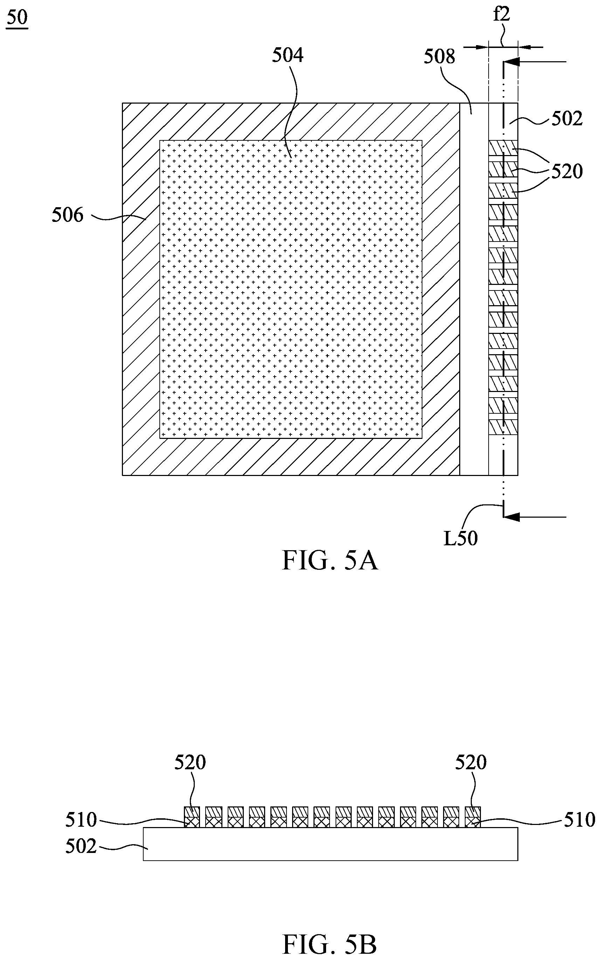

FIG. 5A shows a plan view of a display device 50 according to some embodiments. FIG. 5B shows a section diagram of the display device 50 along an axis L50 according to some embodiments.

In some embodiments, the display device 50 includes a substrate 502, a light emitting layer 504, a metal layer 506, a protective layer 508, an electrode 510 and a release layer 520. Compared to the embodiments in FIG. 3A to FIG. 4B in which a release layer is shaped as a strip in overall, the release layer 520 is formed over the electrode 510 in the embodiments in FIG. 5A and FIG. 5B. In some embodiments, the release layer 520 covers the electrode 510. In some embodiments, the release layer 520 does not cover the protective layer 508 or the metal layer 506.

In some embodiments, the release layer 520 has a width f2. In some embodiments, the release layer 520 covers the electrode 510 but does not cover the protective layer 508. In some embodiments, the width f2 of the release layer 520 can be less than the width f1 of the release layers in FIG. 3A to FIG. 4B. In some embodiments, a plurality of electrodes 510 can be separated from one another. In some embodiments, a plurality of release layer 520 can be separated from one another.

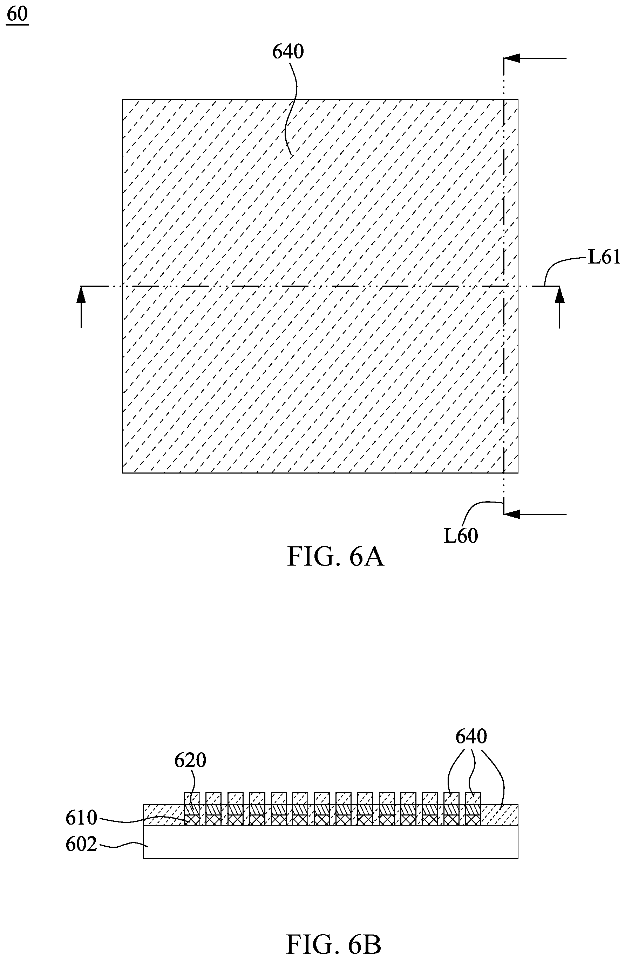

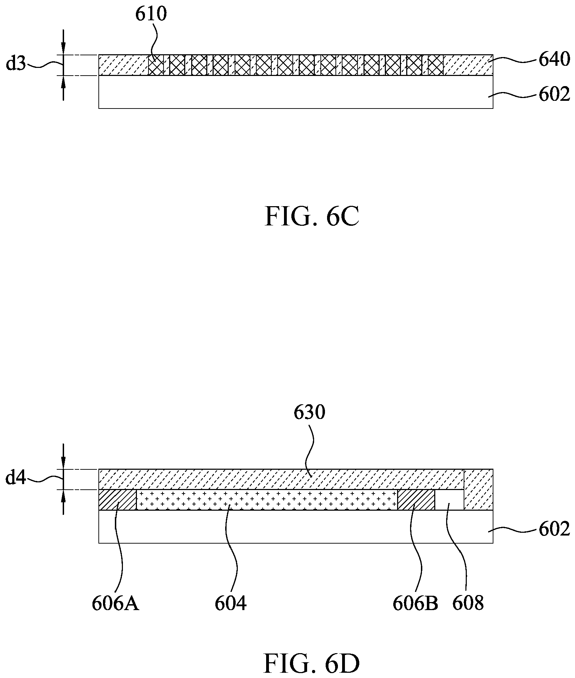

FIG. 6A shows a plan view of a display device 60 according to some embodiments. FIG. 6B shows a section diagram of the display device 60 along an axis L60 according to some embodiments. FIG. 6C shows another section diagram of the display device 60 along the axis L60 according to some embodiments. FIG. 6D shows a section diagram of the display device 60 along an axis L61 according to some embodiments.

In some embodiments, the display device 60 includes a substrate 602, a light emitting layer 604, metal layers 606A and 606B, a protective layer 608, an electrode 610, a release layer 620, and encapsulation layers 630 and 640. In some embodiments, the release layer 620 is formed over the electrode 610. In some embodiments, the encapsulation layer 640 can be formed over the substrate 602 and adjacent to the electrode 610. In some embodiments, the encapsulation layer 640 can cover a plurality of electrodes 610 and be adjacent to the plurality of electrodes 610. In some embodiments, the plurality of electrodes 610 are surrounded by the encapsulation layer 640.

FIG. 6C shows a schematic diagram of an embodiment in which the release layer 620 in FIG. 6b is removed. In some embodiments, the plurality of electrodes 610 are surrounded by the encapsulation layer 640 having a thickness d3. In some embodiments, the electrode 630 after release has an upper surface exposed from the encapsulation layer 640. In the embodiment in FIG. 6D, the encapsulation layer 630 having a thickness d4 is formed over the light emitting layer 604, the metal layers 606A and 606B and the protective layer 608. In some embodiments, the encapsulation layer 630 covers the light emitting layer 604, the metal layers 606A and 606B and the protective layer 608.

In some embodiments, a difference between the thickness d3 of the encapsulation layer 640 next to the electrode 610 and the thickness d4 of the encapsulation layer 630 on the light emitting layer 604 is less than 10%. In some embodiments, the thickness d3 of the encapsulation layer 640 next to the electrode 610 is substantially equal to the thickness d4 of the encapsulation layer 630 on the light emitting layer 604.

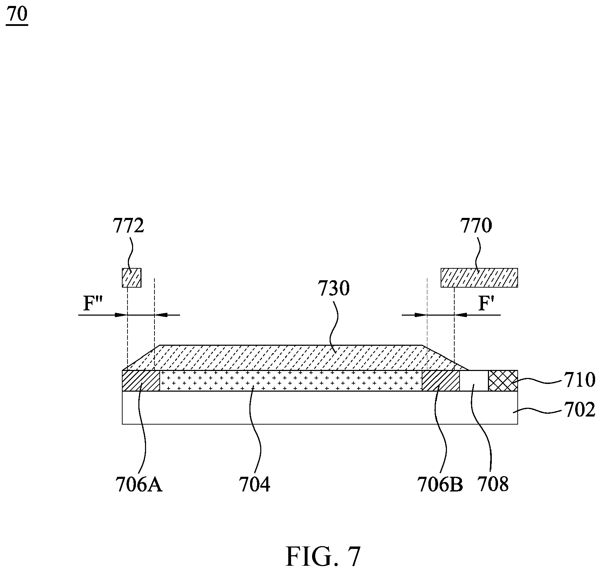

FIG. 7 shows a section diagram of a display device 70 according to some embodiments.

In some embodiments, the display device 70 includes a substrate 702, a light emitting layer 704, metal layers 706A and 706B, a protective layer 708, an electrode 710 and a release layer 730. In some embodiments, masks 770 and 772 can be used to form the encapsulation layer 730 of the display device 70 by means of such as PECVD. In some embodiments, the masks 770 and 772 interfere with and penetrate an airflow during film formation of the PECVD, and thus regions F' and F" with a shadow effect are resulted. The regions F' and F" are defined as ranges of the encapsulation layer 730 having a thickness between 10% and 90% of a target thickness. In general, the regions F' and F" with a shadow effect have lengths between about 200 um and about 300 um, such that the bezel of the display device 70 cannot be narrowed, causing complications in product design and application. For example, the encapsulation layer 730 can even extend to over the protective layer 708 due to influences of the shadow effect, such that the bezel of the display device 70 cannot be narrowed.

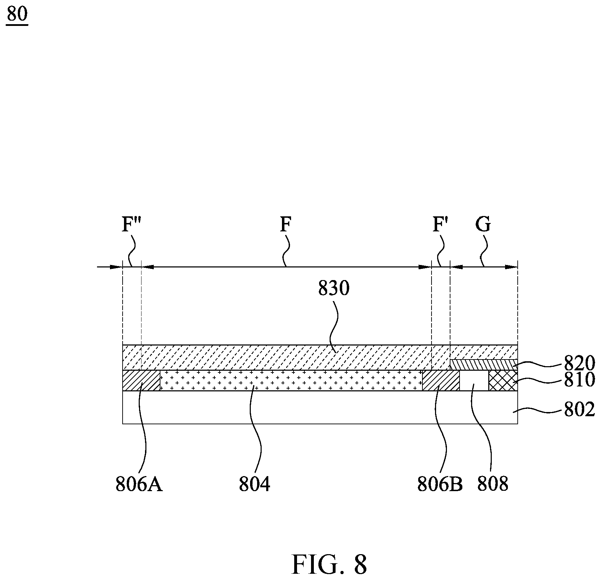

FIG. 8 shows a section diagram of a display device 80 according to some embodiments.

In some embodiments, the display device 80 includes a substrate 802, a light emitting layer 804, metal layers 806A and 806B, a protective layer 808, an electrode 810, a release layer 820, and an encapsulation layer 830. Compared to the embodiment in FIG. 7, the display device 80 in FIG. 8 does not require any mask, and thus desirable influences caused by the shadow effect are prevented, hence effectively reducing dimensions of the bezel of a display.

As shown in FIG. 8, the release layer 820 in a region G covers the protective layer 808, the electrode 810 and a portion of the metal layer 806B. In some embodiments, the encapsulation layer 830 is formed over the light emitting layer 804, the metal layers 806A and 806B and the release layer 820. Once the release layer 820 in the region G and the encapsulation layer 830 thereon are removed, borders of the encapsulation layer 830 fall within a range of the metal layer 806B. Thus, compared to the display device 70 in FIG. 7, the bezel of the display device 80 can be further narrowed.

Moreover, since the shadow effect is eliminated, a thickness of the encapsulation layer 830 in the regions F' and F" is substantially constant.

In some embodiments, the thickness of the encapsulation layer 830 in the regions F' and F" is substantially equal to the thickness of the encapsulation layer 830 in a region F above the light emitting layer 804. In some embodiments, the thickness of the encapsulation layer 830 on the light emitting layer 804 is substantially equal to the thickness of the encapsulation layer 830 on the metal layer 806B. In some embodiments, a difference between the thickness of the encapsulation layer 830 on the light emitting layer 804 and the thickness of the encapsulation layer 830 on the metal layer 806B is less than 10%.

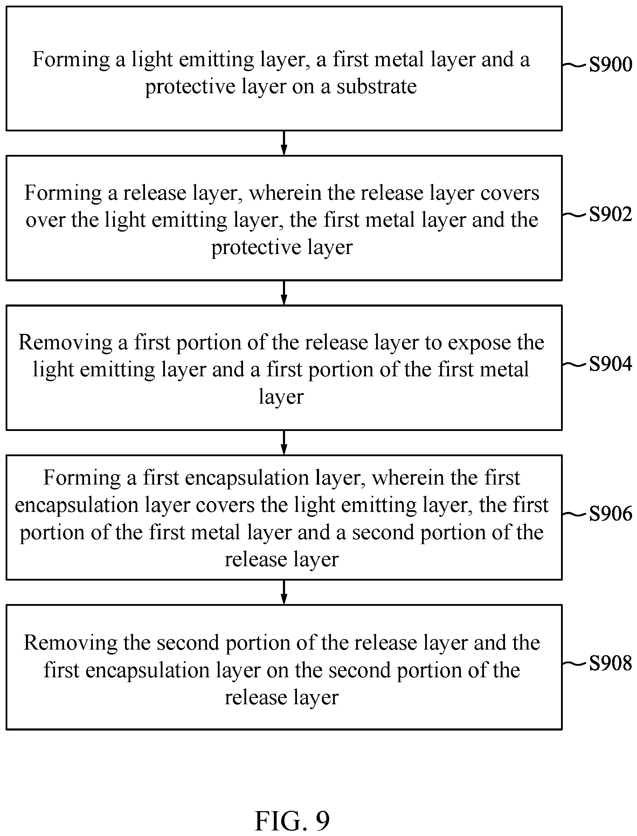

FIG. 9 shows a flowchart of a method for manufacturing a display device according to some embodiments. In step S900, a light emitting layer, a first metal layer and a protective layer are formed on a substrate. In step S902, a release layer is formed, wherein the release layer covers over the light emitting layer, the first metal layer and the protective layer. In step S904, a first portion of the release layer is removed to expose the light emitting layer and a first portion of the first metal layer. In step S906, a first encapsulation layer is formed, wherein the first encapsulation layer covers the light emitting layer, the first portion of the first metal layer and a second portion of the release layer. In step S908, the second portion of the release layer and the first encapsulation layer on the second portion of the release layer are removed.

The present disclosure accordingly provides a method for manufacturing a display device, the method including: forming a light emitting layer, a first metal layer and a protective layer on a substrate, wherein the first metal layer is located between the light emitting layer and the protective layer; forming a release layer, wherein the release layer covers cover over the light emitting layer, the first metal layer and the protective layer; removing a first portion of the release layer to exposed the light emitting layer and a first portion of the first metal layer; and forming a first encapsulation layer, which covers the light emitting layer, the first portion of the first metal layer and the second portion of the release layer, wherein a thickness of the first encapsulation layer on the light emitting layer is substantially equal to a thickness of the first encapsulation layer on the first portion of the first metal layer.

In some embodiments, the first portion of the first metal layer is adjacent to the light emitting layer.

In some embodiments, the second portion of the release layer and the first encapsulation layer on the second portion of the release layer are removed.

In some embodiments, a release force between the first metal layer and the first encapsulation layer is greater than a release force between the first metal layer and the second portion of the release layer.

In some embodiments, the release layer includes a fluorine compound.

In some embodiments, the first encapsulation layer is formed by means of plasma enhanced chemical vapor deposition (PECVD), wherein a resistance of the release layer against the PECVD process prevents the release layer from being impaired by the PECVD process..

In some embodiments, the release force of the release layer is less than 10 g/mm.

In some embodiments, the method further includes: forming an electrode on the substrate; and forming the second portion of the release layer on the electrode, wherein the electrode is adjacent to the protective layer.

In some embodiments, the method further includes: forming a second metal layer on the substrate, wherein the light emitting layer is located between the first metal layer and the second metal layer; and forming a third portion of the release layer on a portion of the second metal layer away from the light emitting layer, wherein the first encapsulation layer covers over the third portion of the release layer and a portion of the second metal layer close to the light emitting layer.

In some embodiments, a thickness of the first encapsulation layer on the light emitting layer is substantially equal to a thickness of the first encapsulation layer on a portion of the second metal layer close to the light emitting layer.

The present disclosure accordingly provides a display device including a substrate, a light emitting layer, a metal layer, a protective layer and a first encapsulation layer. The light emitting layer is disposed on the substrate. The metal layer is disposed on the substrate. The protective layer is disposed on the substrate. The metal layer is located between the light emitting layer and the protective layer. The first encapsulation layer covers the light emitting layer and a first portion of the metal layer. A thickness of the first encapsulation layer on the light emitting layer is substantially equal to a thickness of the first encapsulation layer on the first portion of the metal layer.

In some embodiments, the display device further includes an electrode and a second encapsulation layer. The electrode is disposed on the substrate. The second encapsulation layer covers the substrate ad is close to the electrode. A difference between a thickness of the second encapsulation layer next to the electrode and a thickness of the first encapsulation layer on the light emitting layer is less than 10%.

In some embodiments, the thickness of the second encapsulation layer next to the electrode is substantially equal to the thickness of the first encapsulation layer on the light emitting layer.

In some embodiments, the first encapsulation layer includes a relatively rough surface, which is between a first sidewall and a second sidewall of the metal layer.

The features of some embodiments are given in brief in the description above for a person skilled in the art to better understand various aspects of the present disclosure. A person skilled in the art would be able to understand that the present disclosure can be used as the basis for designing or modifying other manufacturing processes and structures so as to implement the same objects and/or the same advantages of the embodiments described in the present application. A person skilled in the art would also be able to understand that such structures do not depart from the spirit and scope of the disclosure of the present application, and various changes, substitutions and replacements may be made by a person skilled in the art without departing from the spirit and scope of the present disclosure.

In addition, the scope of the present application is not limited to the specific embodiments of the processes, machinery, manufacturing, substance compositions, means, methods or steps given in the detailed description. A person of ordinary skill in the art would be able to understand from the disclosed details of the present that existing or future processes, machinery, manufacturing, substance compositions, means, methods or steps that have the same functions or achieve substantially the same results as the corresponding embodiments given in the literature can be used according to the present disclosure. Accordingly, these processes, machinery, manufacturing, substance compositions, means, methods and steps are to be encompassed within the scope of the appended claims of the present application.

## Claims

1. A method for manufacturing a display device, comprising:
forming a light emitting layer, a first metal layer and a protective layer on a substrate, wherein the first metal layer is located between the light emitting layer and the protective layer;
forming a release layer, wherein the release layer covers over the light emitting layer, the first metal layer and the protective layer;
removing a first portion of the release layer to expose the light emitting layer and the first portion of the first metal layer; and
forming a first encapsulation layer, which covers the light emitting layer, the first portion of the first metal layer, and a second portion of the release layer, wherein a thickness of the first encapsulation layer on the light emitting layer is substantially equal to a thickness of the first encapsulation layer on the first portion of the first metal layer.

2. The method according to claim 1, wherein the first portion of the first metal layer is adjacent to the light emitting layer.

3. The method according to claim 1, further comprising:
removing the second portion of the release layer and the first encapsulation layer on the second portion of the release layer.

4. The method according to claim 1, wherein a release force between the first metal layer and the first encapsulation layer is greater than a release force between the first metal layer and the second portion of the release layer.

5. The method according to claim 1, wherein the release layer comprises a fluorine compound.

6. The method according to claim 1, wherein the first encapsulation layer is formed by plastic enhanced chemical vapor deposition, and wherein a resistance of the release layer against the PECVD process prevents the release layer from being impaired by the PECVD process.

7. The method according to claim 1, wherein a release force of the release layer is less than 10 g/mm.

8. The method according to claim 1, further comprising:
forming an electrode on the substrate; and
forming the second portion of the release layer on the electrode, wherein the electrode is adjacent to the protective layer.

9. The method according to claim 8, further comprising:
forming a second metal layer on the substrate, wherein the light emitting layer is located between the first metal layer and the second metal layer;
forming a third portion of the release layer on a portion of the second metal layer away from the light emitting layer, wherein the first encapsulation layer covers over the third portion of the release layer and a portion of the second metal layer close to the light emitting layer.

10. The method according to claim 9, wherein a thickness of the first encapsulation layer on the light emitting layer is substantially equal to a thickness of the first encapsulation layer on the portion of the second metal layer close to the light emitting layer.

11. A display device, comprising:
a substrate;
a light emitting layer, disposed on the substrate;
a metal layer, disposed on the substrate;
a protective layer, disposed on the substrate, wherein the metal layer is located between the light emitting layer and the protective layer; and
a first encapsulation layer, covering the light emitting layer and a first portion of the metal layer,
wherein a thickness of the first encapsulation layer on the light emitting layer is substantially equal to a thickness of the first encapsulation layer on the first portion of the metal layer.

12. The display device according to claim 11, the display device further comprising:
an electrode, disposed on the substrate; and
a second encapsulation layer, covering the substrate and close to the electrode, wherein a difference between a thickness of the second encapsulation layer next to the electrode and a thickness of the first encapsulation layer on the light emitting layer is less than 10%.

13. The display device according to claim 12, wherein the thickness of the second encapsulation layer next to the electrode is substantially equal to the thickness of the first encapsulation layer on the light emitting layer.

14. The display device according to claim 11, wherein the first encapsulation layer comprises a relatively rough surface, which is located between a first sidewall and a second sidewall of the metal layer.
